(19) Europäisches Patentamt European Patent Office Office européen des brevets

(11) **EP 4 545 679 A1**

(12) **EUROPEAN PATENT APPLICATION**
published in accordance with Art. 153(4) EPC

(43) Date of publication:
**30.04.2025 Bulletin 2025/18**

(21) Application number: **24840685.2**

(22) Date of filing: **03.06.2024**

(51) International Patent Classification (IPC):
**C23C 16/42** (2006.01)    **C01B 32/956** (2017.01)

(52) Cooperative Patent Classification (CPC):
**C01B 32/956; C23C 16/42**

(86) International application number:
**PCT/JP2024/020131**

(87) International publication number:
**WO 2025/047028 (06.03.2025 Gazette 2025/10)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **25.08.2023 JP 2023137216**

(71) Applicant: **Tokai Carbon Co., Ltd.**
**Minato-ku**
**Tokyo 107-8636 (JP)**

(72) Inventors:
• **IMAGAWA, Mayuri**
  **Tokyo 1078636 (JP)**
• **OISHI, Shohei**
  **Tokyo 1078636 (JP)**
• **KUROYANAGI, Akihiro**
  **Tokyo 1078636 (JP)**
• **YASHIKIDA, Reiko**
  **Tokyo 1078636 (JP)**

(74) Representative: **Eisenführ Speiser**
**Patentanwälte Rechtsanwälte PartGmbB**
**Postfach 10 60 78**
**28060 Bremen (DE)**

(54) **POLYCRYSTALLINE SIC MOLDED BODY**

(57)    Regarding a SiC formed body, a small crystal grain size is considered to be preferable, because general wear occurs first at the crystal grain boundaries and therefore the small grain size leads to a reduction in particles generated during the wear. Meanwhile, a large crystal grain size leads to a reduction in volume resistivity, making a SiC formed body suitable for use as a heater among components for semiconductor manufacturing apparatuses. For these reasons, provided are a polycrystalline SiC formed body which has a low volume resistivity and a crystal grain size controlled within a specific range, and a method for producing the same. The polycrystalline SiC formed body has an average crystal grain size of 5.5 $\mu$m to 25.0 $\mu$m, a nitrogen concentration of $0.27\times10^{20}$ atoms/cm$^3$ to $5.4\times10^{20}$ atoms/cm$^3$, and a product of carrier density $\times$ Hall mobility of $4.0\times10^{20}$ atoms/cmVsec to $100\times10^{20}$ atoms/cmVsec.

FIG.1

EP 4 545 679 A1

**Description**

Technical Field

The present invention relates to a polycrystalline SiC formed body and a method for producing the same.

Background Art

Polycrystalline SiC (silicon carbide) formed bodies are excellent in mechanical strength properties, electrical properties, heat resistance, chemical stability, and so on and are used in various industrial applications. For example, a polycrystalline SiC formed body is used in a high temperature atmosphere and a high purity ambient. Common applications include dummy wafers and components for semiconductor manufacturing apparatuses such as members for making up semiconductor manufacturing apparatuses.

For example, polycrystalline SiC formed bodies as components for semiconductor manufacturing apparatuses are plate-shaped in general.

A surface of a polycrystalline SiC formed body in a CVD film growth direction is used as a major surface. In the case of a plate-shaped polycrystalline SiC formed body, both the front and back surfaces can be used as major surfaces, except for the side surfaces. The thickness of a polycrystalline SiC formed body varies according to a film formation time, and a polycrystalline SiC formed body can be formed with a desired thickness. Disc-shaped polycrystalline SiC formed bodies with diameters of about 100 mm to 300 mm are known.

As polycrystalline SiC formed bodies as components for semiconductor manufacturing apparatuses, cylindrical polycrystalline SiC formed bodies each obtained by forming a film on a rod-shaped substrate may be also used suitably. Regarding a polycrystalline SiC formed body in this case, when the polycrystalline SiC formed body is cylindrical and major surfaces are set in CVD film growth directions, both of an outer surface and an inner surface of the cylinder may be used as the major surfaces. The thickness of a polycrystalline SiC formed body varies according to a film formation time, and a polycrystalline SiC formed body can be formed with a desired thickness. Polycrystalline SiC formed bodies with cylinder diameters of about 5 mm to 700 mm are known.

Regarding a SiC formed body having a specific resistivity, Patent Literature 1 describes silicon carbide for components for semiconductor manufacturing, the silicon carbide obtained by the CVD method and characterized in that the content of the nitrogen elements is 0.1 to 100 ppm, the content of metal elements other than silicon is 10 ppm or less, the specific electrical resistance is 0.01 to 10 $\Omega \cdot cm$, and a variation of the specific electrical resistance is 10% or less. As a specific example thereof, a silicon carbide formed body having a specific electrical resistance of 0.1 to 5 $\Omega \cdot cm$ is disclosed.

Patent Literature 2 describes an independent article containing low-resistivity silicon carbide which has an electrical resistivity of less than 0.9 $\Omega \cdot cm$ and which is chemically deposited, and discloses a silicon carbide deposit having a resistivity of 0.25 to 0.9 $\Omega \cdot cm$ as a specific example thereof.

Citation Lists

Patent Literatures

Patent Literature 1: Japanese Patent No. 4595153
Patent Literature 2: Japanese Patent Application Publication No. 2001-316821

Summary of Invention

Problems to be solved by the invention

Regarding a SiC formed body, a small crystal grain size is considered to be preferable because general wear occurs first at the crystal grain boundaries and therefore the small size leads to a reduction in particles generated during the wear. On the other hand, a large crystal grain size leads to a reduction in the volume resistivity, making the SiC formed body suitable for use such as a heater, among components for semiconductor manufacturing apparatuses.

Therefore, the present invention has an object to provide a polycrystalline SiC formed body which has a low volume resistivity and a crystal grain size controlled within a specific range, and a method for producing the same.

Means for solution of the problems

As a result of studies, the present inventors fount that the above object can be achieved by the following means.

[1] A polycrystalline SiC formed body having an average crystal grain size of 5.5 $\mu$m to 25.0 $\mu$m, a nitrogen concentration of $0.27 \times 10^{20}$ atoms/cm$^3$ to $5.4 \times 10^{20}$ atoms/cm$^3$, and a product of carrier density $\times$ Hall mobility of $4.0 \times 10^{20}$ atoms/cmVsec to $100 \times 10^{20}$ atoms/cmVsec.
[2] The polycrystalline SiC formed body according to [1], wherein a volume resistivity is 0.0200 $\Omega \cdot$cm or less.
[3] A method for producing the polycrystalline SiC formed body according to [1], comprising the steps of: placing a substrate in a CVD reactor; heating the substrate; and forming a polycrystalline SiC film on the heated substrate by a CVD method by introducing a mixture gas containing a raw material gas and a nitrogen-containing gas into the CVD reactor, wherein the step of forming the film is carried out under a condition at a film formation rate of 15 $\mu$m/h to 60 $\mu$m/h with a residence time of 10 seconds to 100 seconds.

Advantageous Effects of Invention

According to the present invention, provided are a polycrystalline SiC formed body which has a low volume resistivity and a crystal grain size controlled within a specific range, and a method for producing the same.

Brief Description of Drawings

[Fig. 1] Fig. 1 is a schematic diagram illustrating an example of a polycrystalline SiC formed body production system.
[Fig. 2] Fig. 2 is a schematic diagram illustrating a modification of a CVD reactor. Description of Embodiments

1: Polycrystalline SiC Formed body

A polycrystalline SiC formed body according to an embodiment of the present invention has an average crystal grain size of 5.5 $\mu$m to 25.0 $\mu$m, a nitrogen concentration of $0.27 \times 10^{20}$ atoms/cm$^3$ to $5.4 \times 10^{20}$ atoms/cm$^3$, and a product of carrier density $\times$ Hall mobility of $4.0 \times 10^{20}$ atoms/cmVsec to $100 \times 10^{20}$ atoms/cmVsec. Having the structure as described above, a polycrystalline SiC formed body which has a low volume resistivity and a crystal grain size controlled within a specific range can be obtained.
In the present specification, the "average crystal grain size" means an "average crystal grain size" calculated in accordance with a "method using area fraction" obtained by Electron Backscatter Diffraction (EBSD).
According to the present embodiment, it is possible to obtain a polycrystalline SiC formed body having an average crystal grain size of 5.5 $\mu$m to 25.0 $\mu$m, a nitrogen concentration of $0.27 \times 10^{20}$ atoms/cm$^3$ to $5.4 \times 10^{20}$ atoms/cm$^3$, and a product of carrier density $\times$ Hall mobility of $4.0 \times 10^{20}$ atoms/cmVsec to $100 \times 10^{20}$ atoms/cmVsec.
The average crystal grain size is, for example, 5.5 $\mu$m to 25.0 $\mu$m, preferably 8.0 $\mu$m to 20.0 $\mu$m, and further preferably 10.0 $\mu$m to 15.0 $\mu$m.
In the present specification, the "nitrogen concentration" means the number of nitrogen atoms per unit volume, atoms/cm$^3$. The nitrogen concentration is obtained by using a dynamic secondary ion mass spectrometry (SIMS).
When the nitrogen concentration is within a range of $0.27 \times 10^{20}$ atoms/cm$^3$ to $5.4 \times 10^{20}$ atoms/cm$^3$, the sufficiently low volume resistivity can be obtained. This nitrogen concentration is equivalent to 200 ppm to 3800 ppm.
This nitrogen concentration is considered to have an extremely high value as a concentration of impurity doped into a polycrystalline SiC formed body, and is a concentration that would otherwise usually exceed a solid solubility limit. In the case where nitrogen is added in an amount exceeding the solid solubility limit, a compound different from SiC is generated, and the resultant product does not exhibit functions required for a polycrystalline SiC formed body. According to the present embodiment, however, use of the production method described below makes it possible for a polycrystalline SiC formed body to be doped with nitrogen at such a nitrogen concentration and to satisfy the properties required for the polycrystalline SiC formed body. The reason why such properties are realized is not clear; however, it is thought that, for example, an excessively low film formation rate lengthens a film formation time and accordingly also lengthens a time for generating a compound different from SiC, which makes doping impossible. On the other hand, it is also thought that an excessively high film formation rate causes the formation of a SiC film to be completed before nitrogen is decomposed into a reactive intermediate, so that a nitrogen doping reaction may not occur sufficiently.
The "product of carrier density $\times$ Hall mobility" is a value calculated from a "carrier density" and a "Hall mobility".
The product of carrier density $\times$ Hall mobility relates to the volume resistivity. According to the present embodiment, when the product of carrier density $\times$ Hall mobility is $4.0 \times 10^{20}$ atoms/cmVsec to $100 \times 10^{20}$ atoms/cmVsec,

a sufficiently low volume resistivity can be obtained.

The polycrystalline SiC formed body may have a product of carrier density $\times$ Hall mobility of more preferably $25 \times 10^{20}$ atoms/cmVsec to $100 \times 10^{20}$ atoms/cmVsec, and further preferably $35 \times 10^{20}$ atoms/cmVsec to $100 \times 10^{20}$ atoms/cmVsec.

The "carrier density" means a density of impurities doped in a SiC formed body. The carrier density can be obtained by using a Hall effect measurement.

For example, the carrier density is $1.0 \times 10^{19}$ atoms/cm$^3$ to $7.0 \times 10^{19}$ atoms/cm$^3$.

The "Hall mobility" is a known parameter and can be obtained by using a Hall effect measurement. For example, the Hall mobility is 10 cm$^2$/Vsec to 150 cm$^2$/Vsec.

According to the present embodiment, the polycrystalline SiC formed body may have a volume resistivity of, for example, 0.0200 $\Omega\cdot$cm or less, and preferably 0.0100 $\Omega\cdot$cm or less. The polycrystalline SiC formed body may have a volume resistivity of more preferably 0.0010 Q-cm or less and further preferably 0.0001 $\Omega\cdot$cm or less.

In a preferred embodiment, the polycrystalline SiC formed body is 3C-SiC.

In a preferred embodiment, the polycrystalline SiC formed body has a major surface. The polycrystalline SiC formed body is preferably plate-shaped and more preferably disc-shaped. In the case of a plate shape, major surfaces of the polycrystalline SiC formed body refer to the front and back surfaces except for the side surfaces. In this case, the thickness of the polycrystalline SiC formed body is, for example, 0.1 mm to 5.0 mm and preferably 0.2 mm to 3.0 mm. In the case of a disc shape, the diameter of the polycrystalline SiC formed body is not particularly limited, but may be, for example, 100 mm to 300 mm and preferably 130 mm to 200 mm.

The polycrystalline SiC formed body may be cylindrical. In the case of a cylindrical shape, major surfaces of the polycrystalline SiC formed body refer to an outer surface and an inner surface of the cylinder. In this case, the thickness of the polycrystalline SiC formed body is, for example, 0.1 mm to 5.0 mm and preferably 0.2 mm to 3.0 mm.

In a more preferred embodiment, the major surface has a (111) peak intensity ratio of 0.25 to 0.50. The "(111) peak intensity ratio" is a parameter indicating the ratio of the diffraction peak intensity of SiC(111) to the total of the diffraction peak intensities of SiC(111), SiC(200), SiC(220), and SiC(311) planes in an X-ray diffraction pattern.

2: Method for Producing Polycrystalline SiC Formed body

The polycrystalline SiC formed body having the above properties can be obtained by the following production method with film formation conditions and the like adjusted. Hereinafter, a method for producing a polycrystalline SiC formed body according to the present embodiment will be described.

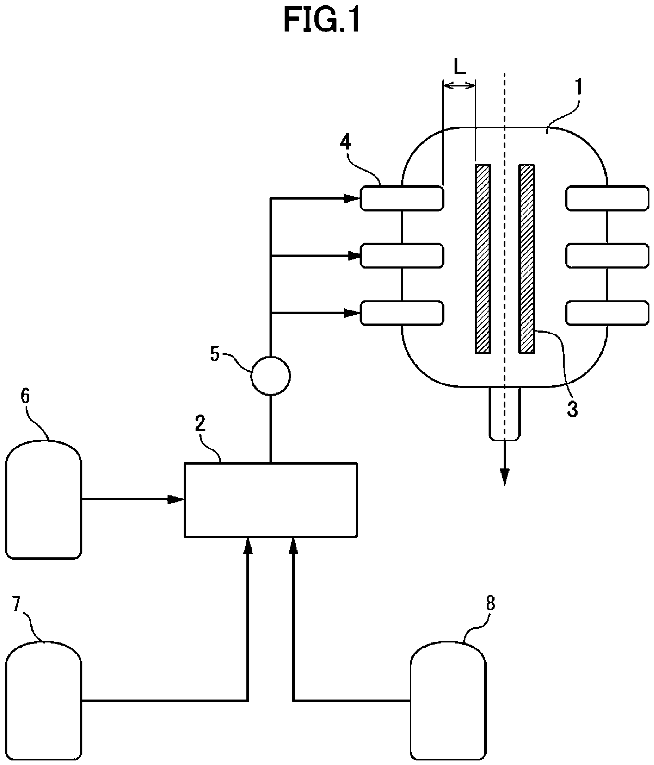

Fig. 1 is a schematic diagram illustrating an example of a production system for use in the method for producing a polycrystalline SiC formed body according to the present embodiment. This production system is provided with a CVD reactor 1 and a mixer 2. The mixer 2 mixes a carrier gas 6, a raw material gas 7 as a supply source of SiC, and a nitrogen-containing gas 8, thereby generating a mixture gas. The mixture gas is supplied at a "flow rate Q" from the mixer 2 to the CVD reactor 1. Substrates 3 (for example, graphite substrates) are placed in the CVD reactor 1. In the CVD reactor 1, the substrates 3 are heated during an operation. The substrates 3 are preferably disc-shaped or rod-shaped. The CVD reactor 1 is provided with nozzles 4 and the mixture gas is introduced to the CVD reactor via these nozzles 4. After the mixture gas is introduced into the CVD reactor, polycrystalline SiC films are formed on the heated substrates 3 by the CVD method. During this process, the polycrystalline SiC films are doped with nitrogen derived from the nitrogen-containing gas. In other words, the polycrystalline SiC films doped with nitrogen are obtained. After removal of the substrates 3, the obtained polycrystalline SiC films are ground as needed. As a result, the polycrystalline SiC formed bodies are obtained.

In the example illustrated in Fig. 1, multiple nozzles 4 are provided. The substrates 3 are placed to extend vertically. The multiple nozzles 4 are provided on both sides of the reactor wall so as to sandwich the substrates 3. In Fig. 1, L denotes a distance between each nozzle tip end (ejection port of the raw material gas) and the corresponding one of the substrates 3.

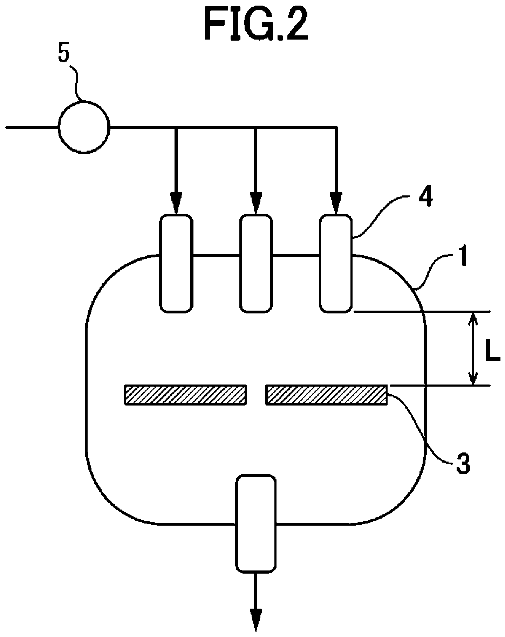

The CVD reactor 1 does not necessarily have to have the structure as illustrated in Fig. 1. Fig. 2 is a diagram illustrating a modification of the CVD reactor 1. In the example illustrated in Fig. 2, multiple nozzles 4 are provided on an upper side of a CVD reactor 1. Substrates 3 are placed to extend horizontally. The CVD reactor 1 may have the structure as illustrated in Fig. 2.

In possible embodiments, the CVD reactors are of a cold-wall type, a hot-wall type, and so on. In a cold-wall type of CVD reactor, the reactor wall and the atmosphere inside the reactor are not directly heated and only a substrate is heated directly. In a hot-wall type of CVD reactor, the entire reactor including the reactor wall and the atmosphere inside the reactor is heated. In the present embodiment, the properties of obtained SiC formed bodies have no difference between the cold-wall type and the hot-wall type.

Also in the present embodiment, the polycrystalline SiC film is formed under the setting of a specific "arrival time $\tau$". Specifically, the film formation is carried out under the condition where the arrival time $\tau$ is 0.02 seconds to 0.10 seconds.

The arrival time $\tau$ refers to a time from when the mixture gas is introduced into the CVD reactor to when the mixture gas arrives at the substrate. Specifically, the arrival time $\tau$ is obtained in accordance with the following formula 1:

$$\text{Arrival Time } \tau = L/u,$$

where L denotes the distance between the ejection port of the raw material gas (nozzle tip end) and the substrate; and u denotes a flow velocity of the mixture gas in the reactor.

The flow velocity u of the mixture gas is obtained in accordance with "flow rate Q/ejection port cross-sectional area A".

The flow rate Q refers to a flow rate of the mixture gas between the mixer and the reactor. The flow rate Q is not particularly limited, but is, for example, 10 l/min to 400 l/min and preferably 50 l/min to 350 l/min.

According to the findings of the present inventors, the arrival time $\tau$ affects a concentration of doped nitrogen, and accordingly affects the carrier density and the Hall mobility. Therefore, optimization of the arrival time $\tau$ makes it possible to obtain a polycrystalline SiC film having a predetermined average grain size, in which the nitrogen concentration and the product of carrier density $\times$ Hall mobility are controlled. The arrival time $\tau$ is preferably 0.02 seconds to 0.10 seconds, more preferably 0.02 seconds to 0.08 seconds, and further preferably 0.02 seconds to 0.06 seconds from the viewpoint that the grain size can be adjusted within the suitable range.

As the raw material gas to serve as the supply source of SiC, either a one-component system (gas containing Si and C) or a two-component system (gas containing Si and gas containing C) may be used.

Examples of the one-component system of raw material gas include methyltrichlorosilane, trichlorophenylsilane, dichloromethylsilane, dichlorodimethylsilane, chlorotrimethylsilane, and so on. As the two-component system of raw material gas, there are a mixture of a silane-containing gas such as trichlorosilane or monosilane with a hydrocarbon gas, and so on.

As the nitrogen-containing gas, any gas capable of doping a polycrystalline SiC film with nitrogen may be used. For example, a nitrogen gas is used as the nitrogen-containing gas.

The carrier gas for use in the film formation is not particularly limited, and for example, a hydrogen gas or the like may be used.

The film formation conditions other than the arrival time $\tau$ are not particularly limited, but, for example, the following conditions may be employed.

The heating temperature during the film formation is set such that the reaction temperature can be, for example, 1300°C to 1400°C and preferably 1300°C to 1350°C. Here, it is preferable that the reactor wall and a heat insulating material in the rector be kept at a temperature at which decomposition products of SiC and the raw material gas will not be deposited (for example, 1000°C or less and preferably 700°C or less).

The flow rate of the nitrogen-containing gas is, for example, 5 vol% to 100 vol% and preferably 30 vol% to 50 vol% with respect to the total flow rate of the flow rate of the nitrogen-containing gas, the flow rate of the raw material gas, and the flow rate of the carrier gas.

The film formation rate is, for example, 15 $\mu$m/h to 60 $\mu$m/h and preferably 15 $\mu$m/h to 40 $\mu$m/h. When the film formation rate is controlled within the above range, the average grain size and the nitrogen concentration can be controlled to predetermined values.

A residence time is, for example, 10 seconds to 100 seconds and preferably 20 seconds to 75 seconds. The residence time refers to a time for which the mixture gas stays in the reactor. When the residence time is controlled within the above range, the average grain size can be controlled to the predetermined value.

[Examples]

Hereinafter, the present invention will be described more specifically by using Examples. Here, the film formation time in Examples and Comparative Examples was selected as needed from a range of 1 hour to 60 hours and the reaction temperature in Examples and Comparative Examples was selected as needed from a range of 1200°C to 1500°C.

(Example 1)

As a CVD reactor, the reactor illustrated in Fig. 1 was prepared. As a substrate, one graphite substrate having a diameter of 160 mm and a thickness of 5 mm was prepared and placed in the CVD reactor.

Then, a polycrystalline SiC film was formed on the substrate under conditions specified in Table 1. Specifically, methyltrichlorosilane (MTS) was used as the raw material gas. An $H_2$ gas was used as the carrier gas. An $N_2$ gas was used as the nitrogen-containing gas. The raw material gas, the carrier gas, and the nitrogen-containing gas were mixed in the mixer 2 to generate a mixture gas. The mixture gas was supplied into the CVD reactor 1. The rate of the mixture gas supplied was set to a value specified as "Gas Rate" in Table 1. The concentrations of the MTS gas, the $H_2$ gas, and the $N_2$ gas in the mixture gas were as specified in Table 1.

The residence time was 22 seconds. The residence time was calculated in accordance with the following formula:

$$\text{Residence Time (seconds)} =$$

$$(\text{Reactor Capacity/Gas Rate}) \times ((20+273)/(\text{Reaction Temperature}+273)) \times 60.$$

The arrival time $\tau$ was 0.03 seconds.

After the film formation, the graphite substrate was taken out from the CVD reactor, followed by periphery processing and division processing. Further, the graphite substrate was removed, so that a polycrystalline SiC formed body having a diameter of 150 mm and a thickness of 0.6 mm was obtained. Moreover, the front and back surfaces thereof were ground by surface grinding processing, so that a polycrystalline SiC formed body having a diameter of 150 mm and a thickness of 0.4 mm was obtained. This formed body was obtained as a polycrystalline SiC formed body according to Example 1.

(Examples 2 to 8 and Comparative Examples 1 to 3)

Polycrystalline SiC films were formed in the same manner as in Example 1. However, the film formation conditions were changed as specified in Table 1.

(Evaluation Methods)

For each of the obtained polycrystalline SiC formed bodies, the (111) peak intensity ratio, the carrier density, the Hall mobility, the nitrogen concentration (SIMS N concentration), the average crystal grain size, and the resistivity were obtained. The method for measuring each of the above values will be described below.

(111) Peak Intensity Ratio

An X-ray diffraction pattern by $2\theta$-$\theta$ method in the center of the polycrystalline SiC formed body was measured by using XRD-6000 manufactured by Shimadzu Corporation under the following conditions.

Cu Target

Voltage: 40.0 kV
Current: 20.0 mA
Divergence Slit: 1.00000 degrees
Scattering Slit: 1.00000 degrees
Receiving Slit: 0.30000 mm
Scan Range: 20.000 degrees to 80.000 degrees
Scan Speed: 4.0000 degrees/min
Sampling Pitch: 0.0200 degrees
Preset Time: 0.30 seconds

On the obtained X-ray diffraction pattern, appropriate background correction was performed, and the diffraction peak intensity in a range of a diffraction angle $2\theta$ of 35.3 degrees to 36.0 degrees was obtained as the peak intensity of the SiC(111) plane of 3C-SiC.

Similarly, the diffraction peak intensity in a range of a diffraction angle $2\theta$ of 41.1 degrees to 41.8 degrees was determined as the peak intensity of the SiC(200) plane.

Similarly, the diffraction peak intensity in a range of a diffraction angle $2\theta$ of 59.7 degrees to 60.3 degrees was determined as the peak intensity of the SiC(220) plane.

Similarly, the diffraction peak intensity in a range of a diffraction angle $2\theta$ of 71.5 degrees to 72.3 degrees was determined as the peak intensity of the SiC(311) plane.

Then, the total value of the diffraction peak intensities of the SiC(111) plane, the SiC(200) plane, the SiC(220) plane, and the SiC(311) plane was obtained. Furthermore, the ratio of the diffraction peak intensity of the SiC(111) to the total value was obtained as the (111) peak intensity ratio.

(Carrier Density and Hall Mobility)

The Hall voltage and the resistivity by the van der Pauw method were measured using Resistest8200 manufactured by Toyo Corporation, and the carrier density and the Hall mobility were calculated (Hall effect measurement). The Hall effect measurement was performed under the following conditions after each sample was cut into a size of approximately 10 mm $\times$ 10 mm $\times$ 0.5 mm and an In electrode was formed on it.

Applied Magnetic Field: 1 T
Applied Current: $1.0 \times 10^{-6}$ A
Measurement Temperature: Room Temperature (295K)

(Nitrogen Concentration)

The nitrogen content in the polycrystalline SiC formed body was measured by using SIMS-4000 manufactured by ATOMIKA.

(Average Crystal Grain Size)

Crystal orientation maps with respect to the normal direction of the major surface of the polycrystalline SiC formed body were obtained by the EBSD method.
The measurement conditions are as follows.

Pretreatment: Chemical Mechanical Polishing
Equipment: FE-SEM JSM-7900F manufactured by JEOL Ltd.

EBSD AZtecHKL manufactured by Oxford Instruments

Image Analysis Software: AZtec Crystal
Measurement Conditions: Voltage: 20 kV

Tilt Angle: 70°
Measurement Region: 800 $\mu$m $\times$ 600 $\mu$m
Measurement Interval: 1.4 $\mu$m
Evaluation Target Crystal System: 3C type SiC (space group 216)

In the measurements under the above conditions, the measurement of a formed body with an average grain size of smaller than 5.5 $\mu$m resulted in unstable analysis, thereby failing to obtain an accurate analysis result, so that such formed body was determined as "unevaluable".
Using the crystal orientation maps measured above, for each of all single regions within the entire region (800 $\mu$m $\times$ 600 $\mu$m), the area of the single region of interest was multiplied by a value obtained by dividing the area of the single region of interest by the total area of an observation region to obtain a product, and then the total value of the obtained products was calculated, so that the average cross-sectional area of the crystal grains was obtained (Area Fraction Method). The diameter of a circle having the same area as the obtained average cross-sectional area of the crystal grains was obtained to calculate the average crystal grain size. Specifically, the analysis was performed by using image analysis software equipped in the EBSD equipment, thereby calculating the average crystal grain size.
On the crystal orientation maps, the average crystal grain size was calculated from a measurement at each of three points on the same measurement-target plane, and the average value of the three points was taken as the average crystal grain size on that measurement-target plane.
A positional relationship among the crystal orientation maps was as follows. On the crystal orientation map for the first point, the center point of the measurement region was obtained. The crystal orientation map for the second point was measured under the setting in which a point shifted in field of view from the above center point by 2000 $\mu$m to 4000 $\mu$m in a certain direction was set as the new center point. Then, the crystal orientation map for the third point was measured under the setting in which a point shifted in field of view by 2000 $\mu$m to 4000 $\mu$m from the center point of the measurement region in the crystal orientation map for the second point was set as the new center point.
The measurement was performed on both of the front and back surfaces, and the larger value was determined as the average crystal grain size of the sample. Here, a threshold was set to 10°.

(Measurement of Volume Resistivity)

In accordance with JISK 7194, the volume resistivity of the polycrystalline SiC formed body was measured with a four-point probe array. Specifically, the volume resistivity was measured by using Loresta GP MCP-T610 manufactured by Mitsubishi Chemical Analytech, Co., Ltd.

(Discussion of Results)

As shown in Tables 1 and 2, the polycrystalline SiC formed bodies in Examples 1 to 8 were formed under the conditions of the film formation rate in the range of 15 $\mu$m/h to 60 $\mu$m/h and the residence time in the range of 10 seconds to 100 seconds. As shown in Table 2, the polycrystalline SiC formed bodies in Examples 1 to 8 had low volume resistivity. In Examples 2 to 8, in particular, the polycrystalline SiC formed bodies had very low volume resistivity (specifically 0.0074 $\Omega \cdot$cm or less). These polycrystalline SiC formed bodies in Examples 1 to 8 had an average crystal grain size of 5.5 $\mu$m to 25.0 $\mu$m, which confirmed that they were SiC formed bodies whose crystal grain sizes were within the specific range. In addition, the nitrogen concentration was $0.27 \times 10^{19}$ atoms/cm$^3$ to $5.4 \times 10^{20}$ atoms/cm$^3$. The product of carrier density $\times$ Hall mobility was $4.0 \times 10^{20}$ atoms/cmVsec to $100 \times 10^{20}$ atoms/cmVsec.

On the other hand, in Comparative Example 1 where the film formation rate was 602 $\mu$m/h, the average crystal grain size was determined as unevaluable, the product of carrier density $\times$ Hall mobility was $3.2 \times 10^{20}$ atoms/cmVsec, which is smaller than those in Examples 1 to 8, and the volume resistivity also exceeded 0.0200 $\Omega \cdot$cm.

Also in Comparative Example 2 where the film formation rate was 911 $\mu$m/h, the average crystal grain size was also determined as unevaluable.

In Comparative Example 3 where the film formation rate was 10 $\mu$m/h, the average crystal grain size was 27.3 $\mu$m, which is larger than those in Examples 1 to 8.

[Table 1]

| | Gas Rate (l/min) | MTS Active (%) | H2 Concentration (%) | N2 Concentration (%) | Residence Time (sec) | Arrival Time (sec) |
|---|---|---|---|---|---|---|
| Example 1 | 340 | 4 | 52 | 44 | 22 | 0.03 |
| Example 2 | 320 | 4 | 52 | 44 | 23 | 0.04 |
| Example 3 | 170 | 4 | 52 | 44 | 44 | 0.05 |
| Example 4 | 165 | 4 | 52 | 44 | 45 | 0.05 |
| Example 5 | 340 | 3 | 51 | 46 | 22 | 0.03 |
| Example 6 | 105 | 4 | 52 | 44 | 71 | 0.03 |
| Example 7 | 91 | 4 | 52 | 44 | 82 | 0.06 |
| Example 8 | 85 | 3 | 51 | 46 | 87 | 0.05 |
| Comparative Example 1 | 41 | 14 | 42 | 44 | 10 | 2.50 |
| Comparative Example 2 | 41 | 14 | 42 | 44 | 10 | 3.14 |
| Comparative Example 3 | 79 | 4 | 52 | 44 | 94 | 0.02 |

[Table 2]

| | (111) Peak Intensity Ratio | Carrier Density ($\times 10^{19}$/cm$^3$) | Hall Mobility (cm$^2$/Vsec) | (*) | Nitrogen Concentration ($\times 10^{20}$/cm$^3$) | Average Grain Size ($\mu$m) | Volume Resistivity ($\Omega \cdot$cm) | Film Formation Rate ($\mu$m/h) |
|---|---|---|---|---|---|---|---|---|
| Example 1 | 0.28 | 1.5 | 47 | 7.1 | 2.5 | 9.9 | 0.0141 | 34 |
| Example 2 | 0.32 | 4.5 | 91 | 41 | 4.0 | 13.3 | 0.0053 | 25 |
| Example 3 | 0.40 | 3.2 | 110 | 35 | 4.7 | 15.4 | 0.0059 | 19 |

(continued)

| | (111) Peak Intensity Ratio | Carrier Density ($\times 10^{19}$/cm$^3$) | Hall Mobility (cm$^2$/Vsec) | (*) | Nitrogen Concentration ($\times 10^{20}$/cm$^3$) | Average Grain Size ($\mu$m) | Volume Resistivity ($\Omega \cdot$cm) | Film Formation Rate ($\mu$m/h) |
|---|---|---|---|---|---|---|---|---|
| Example 4 | 0.38 | 6.1 | 98 | 60 | 4.6 | 18.3 | 0.0012 | 18 |
| Example 5 | 0.45 | 3.9 | 75 | 29 | 5.4 | 9.6 | 0.0074 | 28 |
| Example 6 | 0.31 | 2.8 | 130 | 39 | 5.0 | 20.2 | 0.0038 | 18 |
| Example 7 | 0.35 | 4.0 | 140 | 52 | 5.1 | 23.6 | 0.0017 | 17 |
| Example 8 | 0.34 | 5.8 | 150 | 84 | 5.4 | 24.1 | 0.0005 | 15 |
| Comparative Example 1 | 0.94 | 1.6 | 20 | 3.2 | 4.7 | - | 0.0223 | 602 |
| Comparative Example 2 | 0.90 | 2.5 | 30 | 7.5 | 1.6 | - | 0.0241 | 911 |
| Comparative Example 3 | 0.31 | 2.5 | 100 | 26 | 0.81 | 27.3 | 0.0082 | 10 |
| (*) Carrier Density$\times$Hall Mobility ($\times 10^{20}$/cmVsec) | | | | | | | | |

Industrial Applicability

Having a large crystal grain size, a polycrystalline SiC formed body has a lowed volume resistivity, and therefore is suitably usable for an application such as a heater among components for semiconductor manufacturing apparatuses.

Reference Signs List

1    CVD reactor
2    mixer
3    substrate
4    nozzle
5    flowmeter
6    carrier gas
7    raw material gas
8    nitrogen-containing gas

**Claims**

**1.** A polycrystalline SiC formed body having

an average crystal grain size of 5.5 $\mu$m to 25.0 $\mu$m,
a nitrogen concentration of $0.27\times10^{20}$ atoms/cm$^3$ to $5.4\times10^{20}$ atoms/cm$^3$, and
a product of carrier density $\times$ Hall mobility of $4.0\times10^{20}$ atoms/cmVsec to $100\times10^{20}$ atoms/cmVsec.

**2.** The polycrystalline SiC formed body according to claim 1, wherein a volume resistivity is 0.0200 $\Omega \cdot$cm or less.

# FIG.1

# FIG.2

## INTERNATIONAL SEARCH REPORT

International application No.

**PCT/JP2024/020131**

| A. | CLASSIFICATION OF SUBJECT MATTER |
|---|---|

*C23C 16/42*(2006.01)i; *C01B 32/956*(2017.01)i
FI:   C23C16/42; C01B32/956

According to International Patent Classification (IPC) or to both national classification and IPC

| B. | FIELDS SEARCHED |
|---|---|

Minimum documentation searched (classification system followed by classification symbols)

C23C16/42; C01B32/956

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2021-082765 A (SUMITOMO METAL MINING CO., LTD.) 27 May 2021 (2021-05-27) entire text, all drawings | 1-2 |
| A | JP 2020-111495 A (SUMITOMO METAL MINING CO., LTD.) 27 July 2020 (2020-07-27) entire text, all drawings | 1-2 |
| A | JP 2021-54666 A (TOKAI CARBON KK) 08 April 2021 (2021-04-08) entire text, all drawings | 1-2 |
| A | JP 2021-54667 A (TOKAI CARBON KK) 08 April 2021 (2021-04-08) entire text, all drawings | 1-2 |

☐ Further documents are listed in the continuation of Box C.　　　☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **29 July 2024** | **13 August 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
**Information on patent family members**

International application No.

**PCT/JP2024/020131**

| Patent document cited in search report | | | Publication date (day/month/year) | Patent family member(s) | | | Publication date (day/month/year) |
|---|---|---|---|---|---|---|---|
| JP | 2021-082765 | A | 27 May 2021 | (Family: none) | | | |
| JP | 2020-111495 | A | 27 July 2020 | (Family: none) | | | |
| JP | 2021-54666 | A | 08 April 2021 | US | 2022/0344452 | A1 | |
| | | | | entire text, all drawings | | | |
| | | | | WO | 2021/060515 | A1 | |
| | | | | EP | 4036284 | A1 | |
| | | | | CN | 114514342 | A | |
| | | | | KR | 10-2022-0068992 | A | |
| | | | | JP | 2022-190038 | A | |
| JP | 2021-54667 | A | 08 April 2021 | US | 2022/0341054 | A1 | |
| | | | | entire text, all drawings | | | |
| | | | | WO | 2021/060516 | A1 | |
| | | | | EP | 4036286 | A1 | |
| | | | | CN | 114430782 | A | |
| | | | | KR | 10-2022-0074864 | A | |

Form PCT/ISA/210 (patent family annex) (July 2022)

13

**EP 4 545 679 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4595153 B
- JP 2001316821 A